# FASCICULE DE BREVET EUROPEEN

(11) **EP 3 111 480 B1**
(45) Date de publication et mention de la délivrance du brevet: **18.09.2019**
(21) Numéro de dépôt: 15706042.7
(22) Date de dépôt: 25.02.2015
(51) Int. Cl.: H01L 27/32

(54) **DISPOSITIF ELECTRONIQUE COMPRENANT UN COMPOSANT OPTO-ELECTRONIQUE ET DEUX TRANSISTORS ORGANIQUES**
ELEKTRONISCHE VORRICHTUNG MIT ORGANISCHER OPTOELEKTRONISCHER KOMPONENTE UND ZWEI ORGANISCHEN TRANSISTOREN
ELECTRONIC DEVICE INCLUDING AN ORGANIC OPTOELECTRONIC COMPONENT AND TWO ORGANIC TRANSISTORS

(30) Priorité: 25.02.2014 FR 1451508
(43) Date de publication de la demande: 04.01.2017
(73) Titulaire: Commissariat à l'Energie Atomique et aux Energies Alternatives, 75015 Paris (FR); ISORG, 38000 Grenoble (FR)
(72) Inventeur: BENWADIH, Mohammed, 94500 Champigny-sur-Marne (FR); VERILHAC, Jean-Marie, 38500 Coublevie (FR)
(74) Mandataire: Cabinet Beaumont
(86) Numéro de dépôt international: PCT/EP2015/053938
(87) Numéro de publication internationale: WO 2015/128380

(56) Documents cités:
- EP-A2- 2 472 583
- US-A1- 2004 041 146
- US-A1- 2008 124 569
- US-A1- 2009 159 875
- US-B2- 8 445 901

## Description

### Domaine

La présente description concerne les dispositifs électroniques réalisés au moins en partie en matériaux organiques, et les dispositifs électroniques comprenant au moins un composant opto-électronique organique et un transistor à effet de champ organique.

### Exposé de l'art antérieur

Un dispositif électronique tel qu'un écran d'affichage ou un capteur d'images peut comprendre une matrice de composants opto-électroniques organiques, par exemple des photodiodes organiques (OPD, de l'anglais Organic Photodiode) ou des diodes électroluminescentes organiques (OLED, de l'anglais Organic Light-Emitting Diode), associés à des transistors organiques à effet de champ (OFET, de l'anglais Organic Field-Effect Transistor).

Il est connu de réaliser des composants opto-électroniques organiques sur un premier support, de réaliser des transistors organiques à effet de champ sur un deuxième support et de rapporter le premier support sur le deuxième support pour relier les transistors à effet de champ aux composants opto-électroniques.

Toutefois, il serait souhaitable de pouvoir réaliser directement sur un même support à la fois les composants opto-électroniques organiques et les transistors organiques. Une difficulté est que les matériaux organiques sont fragiles de sorte que les étapes de fabrication des composants opto-électroniques organiques peuvent entraîner une dégradation des transistors ou inversement lorsque ces composants sont formés successivement sur un même support. À titre d'exemple, une couche d'un matériau organique déjà déposée peut notamment être détériorée par le solvant utilisé pour le dépôt ultérieur d'une couche d'un autre matériau organique.

A titre d'illustration d'un dispositif électronique comprenant une diode électroluminescente organique intégrée avec un transistor organique, on peut citer le brevet US2004/0041146.

### Résumé

Un mode de réalisation vise à pallier tout ou partie des inconvénients des dispositifs électroniques comprenant des composants opto-électroniques et des transistors à effet de champ au moins en partie réalisés en matériaux organiques et des procédés de fabrication de tels dispositifs connus.

Un autre mode de réalisation vise à former les composants opto-électroniques et les transistors à effet de champ directement sur le même support.

Un autre mode de réalisation vise à améliorer les performances des transistors à effet de champ de ces dispositifs électroniques.

Ainsi, un mode de réalisation prévoit un dispositif électronique comprenant au moins un composant opto-électronique comprenant une première couche active, une première électrode et une deuxième couche d'interface entre la première couche et la première électrode et au moins un premier transistor à effet de champ comprenant une première portion semiconductrice et une première grille et au moins une troisième couche entre la première grille et la première portion semiconductrice, la troisième couche étant du même matériau que la deuxième couche.

Le dispositif comprend, en outre, une quatrième couche diélectrique interposée entre la troisième couche et la première grille.

Selon un mode de réalisation, la résistance électrique de la troisième couche est supérieure ou égale à 10⁹ Ω/□.

Selon un mode de réalisation, l'épaisseur de la troisième couche est comprise entre 0,1 nm et 500 nm.

Selon un mode de réalisation, la première couche comprend au moins un premier matériau organique.

Selon un mode de réalisation, la première portion semiconductrice comprend un deuxième matériau organique.

Selon un mode de réalisation, la deuxième couche comprend un matériau choisi parmi l'oxyde de zinc, l'oxyde de titane, le carbonate de césium ou un mélange d'au moins deux de ces composés.

Selon un mode de réalisation, la troisième couche est un prolongement de la deuxième couche.

Le dispositif comprend une deuxième électrode et une quatrième couche d'interface entre la première couche et la deuxième électrode et comprend un deuxième transistor à effet de champ comprenant une deuxième portion semiconductrice, une deuxième grille et au moins une cinquième couche entre la deuxième grille et la deuxième portion semiconductrice, la cinquième couche étant du même matériau que la quatrième couche.

Selon un mode de réalisation, la cinquième couche est un prolongement de la quatrième couche.

Selon un mode de réalisation, le premier transistor est de type N et le deuxième transistor est de type P.

Selon un mode de réalisation, le dispositif comprend un support, la première grille reposant sur une face du support.

Selon un mode de réalisation, le dispositif comprend un support ayant des première et deuxième faces opposées, le composant opto-électronique étant disposé du côté de la première face et le premier transistor étant disposé du côté de la deuxième face.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une coupe, partielle et schématique, d'un mode de réalisation d'un dispositif électronique comprenant une photodiode organique et un transistor OFET ;
la figure 2 représente des courbes d'évolution de la tension de grille en fonction du courant entre le drain et la source du transistor OFET du dispositif électronique représenté en figure 1 et d'un transistor OFET connu ;
les figures 3A à 3H sont des coupes, partielles et schématiques, de structures obtenues à des étapes successives d'un mode de réalisation d'un procédé de fabrication du dispositif électronique représenté en figure 1 ;
les figures 4 à 6 sont des coupes latérales, partielles et schématiques, d'autres modes de réalisation d'un dispositif électronique comprenant une photodiode organique et un transistor organique à effet de champ ; et
les figures 7A et 7B, sont des coupes, partielles et schématiques, de structures obtenues à des étapes successives d'un mode de réalisation d'un procédé de fabrication du dispositif électronique représenté en figure 6.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. De plus, seuls les étapes et éléments utiles à la compréhension des modes de réalisation décrits sont représentés et détaillés. En particulier, les systèmes de polarisation et de commande des dispositifs électroniques sont bien connus de l'homme du métier et ne sont pas décrits. En outre, dans la suite de la description, les expressions "sensiblement", "environ" et "approximativement" signifient "à 10 % près".

Dans la suite de la description, on appelle composant électronique organique, notamment un composant opto-électronique ou un transistor, un composant électronique dont au moins une partie est réalisée en un matériau organique.

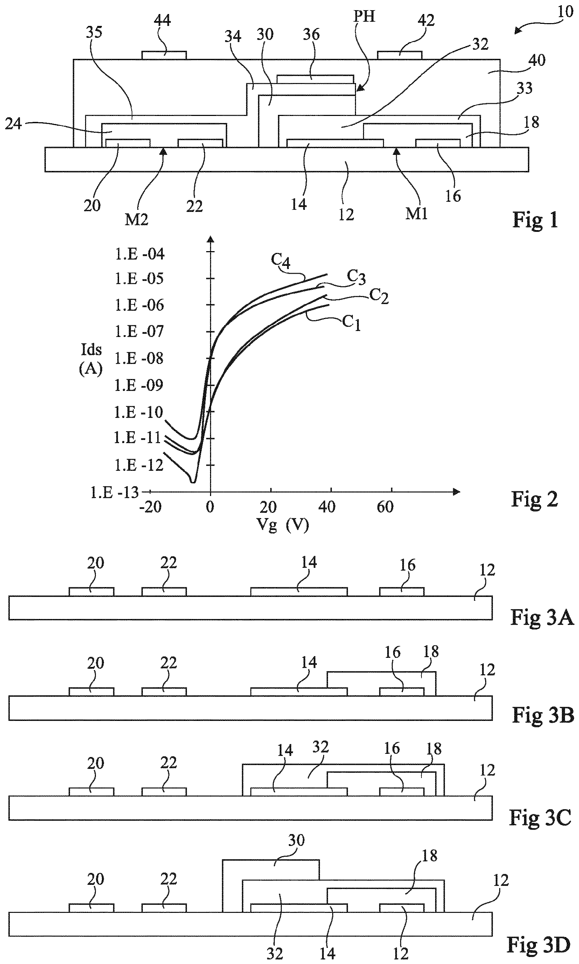

La figure 1 représente un mode de réalisation d'un dispositif électronique 10 selon l'invention comprenant au moins des composants opto-électroniques et des transistors organiques à effet de champ. Dans le présent mode de réalisation, le composant opto-électronique est une photodiode. Toutefois, le composant opto-électronique peut être tout type de composant adapté à l'émission d'un rayonnement électromagnétique, par exemple une diode électroluminescente, ou à la capture d'un rayonnement électromagnétique. En figure 1, on a représenté une seule photodiode PH associée à deux transistors à effet de champ M1 et M2.

Le dispositif opto-électronique 10 comprend un support 12. Le transistor M1 comprend deux électrodes métalliques 14, 16 reposant sur le support 12 et formant les bornes de puissance du transistor M1, c'est-à-dire les électrodes de source et de drain du transistor M1. Le transistor M1 comprend une portion semiconductrice 18 recouvrant au moins partiellement les électrodes 14, 16 et s'étendant sur le support 12 entre les électrodes 14, 16. A titre d'exemple, la portion semiconductrice 18 est en un matériau organique. A titre d'exemple, la portion semiconductrice 18 transporte favorablement les électrons. Elle est par exemple dopée de type N. Le transistor M2 comprend des électrodes 20, 22 reposant sur le support 12 et formant les bornes de puissance du transistor M2. Le transistor M2 comprend, en outre, une portion semiconductrice 24 recouvrant au moins partiellement les électrodes 20, 22 et s'étendant sur le support 12 entre les électrodes 20, 22. A titre d'exemple, la portion semiconductrice 24 est en un matériau organique. A titre d'exemple, la portion semiconductrice 24 transporte favorablement les trous. Elle est par exemple dopée de type P.

La photodiode PH comprend une couche active 30 interposée entre deux couches d'interface 32, 34. La couche d'interface 32 recouvre au moins partiellement l'électrode 14 qui forme également une première électrode de la photodiode PH, par exemple la cathode. Une portion conductrice 36 recouvre la couche d'interface 34. La portion conductrice 36 forme la deuxième électrode de la photodiode PH, par exemple l'anode.

Dans le présent mode de réalisation, de façon avantageuse, la couche d'interface 32 comprend une portion 33 qui recouvre la portion semiconductrice 18 et la couche d'interface 34 comprend une portion 35 qui recouvre la portion semiconductrice 24.

Le dispositif 10 comprend une couche diélectrique 40 qui recouvre la totalité de la structure, notamment à la fois la couche d'interface 34, l'électrode 36 et la couche d'interface 32. L'empilement comprenant la portion 33 de la couche d'interface 32 recouvrant la portion semiconductrice 18 et la partie de la couche diélectrique 40 recouvrant la portion 33 joue le rôle d'oxyde de grille du transistor M1. L'empilement comprenant la portion 35 de la couche d'interface 34 recouvrant la portion semiconductrice 24 et la partie de la couche diélectrique 40 recouvrant la portion 35 joue le rôle d'oxyde de grille du transistor M2. Le dispositif 10 comprend, en outre, des portions conductrices 42, 44 sur la couche diélectrique 40. La portion conductrice 42 correspond à la grille du transistor M1 et la portion conductrice 44 correspond à la grille du transistor M2.

La couche d'interface 32 permet d'aligner le travail de sortie de l'électrode 14 avec l'affinité électronique du matériau accepteur utilisé dans la couche active 30 et la couche d'interface 34 permet d'aligner le travail de sortie de l'électrode 36 avec le potentiel d'ionisation du matériau donneur utilisé dans la couche active 30. Suivant le mode de polarisation de la diode, les couches d'interface 32, 34 facilitent la collection, l'injection ou le blocage des charges depuis les électrodes 14, 36 dans la couche active 30. L'épaisseur des couches d'interface 32, 34 est de préférence comprise entre 0,1 nm et 500 nm. De préférence, les couches d'interface 32, 34 ont une résistance électrique supérieure à 10⁹ Ω/□, de préférence supérieure ou égale à 10¹² Ω/□. La résistance électrique élevée des couches d'interface 32, 34 permet d'éviter la formation d'un court-circuit avec les portions semiconductrices 24, 18.

La portion 33 de la couche d'interface 32 qui est interposée entre la portion semiconductrice 18 et la couche diélectrique 40 protège la portion semiconductrice 18 lors de la fabrication du reste du dispositif 10. La couche d'interface 34 qui est interposée entre la portion semiconductrice 24 et la couche diélectrique 40 permet de protéger la portion semiconductrice 24 lors de la fabrication du reste du dispositif 10. En outre, les couches d'interface 32, 34 permettent de diminuer l'épaisseur de la couche diélectrique 40. Elles peuvent également permettre de protéger les couches semiconductrices 18 et 24 par rapport à la redissolution éventuelle dans le solvant ou les solvants de la couche diélectrique 40.

Lorsque le dispositif 10 est destiné à être éclairé au travers du support 12, c'est-à-dire depuis le bas en figure 1, le support 12, l'électrode 14 et la couche d'interface 32 sont de préférence au moins partiellement transparents. Lorsque le dispositif 10 est destiné à être éclairé au travers de la couche diélectrique 40, c'est-à-dire depuis le haut en figure 1, l'électrode 36, la couche diélectrique 40 et la couche d'interface 34 sont de préférence au moins partiellement transparentes.

Dans le mode de réalisation représenté en figure 1, une borne de puissance du transistor M1 est commune avec une électrode de la photodiode PH. A titre de variante, une borne de puissance du transistor M2 peut être commune avec une électrode de la photodiode PH ou aucune des bornes de puissance des transistors M1 et M2 n'est commune avec une électrode de la photodiode PH.

Le support 12 est, par exemple, un support rigide, notamment en verre ou un support flexible, par exemple en polymère ou en un matériau métallique. Des exemples de polymère sont le polyéthylène naphtalène (PEN), le polyéthylène téréphtalate (PET), le kapton, ou le polyétheréthercétone (PEEK). L'épaisseur du support 12 est, par exemple, comprise entre 20 µm et 1 cm, par exemple d'environ 125 µm.

Les électrodes 14, 16, 20, 22 peuvent être réalisées en un oxyde conducteur transparent (TCO, de l'anglais Transparent Conducting Oxide), en nanotubes de carbone, en graphène, en un polymère conducteur, en un métal ou en un mélange ou un alliage d'au moins deux de ces composés.

Des exemples de TCO adaptés à la réalisation des électrodes 14, 16, 20, 22, 36, 42, 44 sont l'oxyde d'indium-étain (ITO, de l'anglais Indium Tin Oxide), l'oxyde d'aluminium-zinc (AZO, de l'anglais Aluminium Zinc Oxide) et l'oxyde de gallium-zinc (GZO, de l'anglais Gallium Zinc Oxide). Des exemples de polymères conducteurs adaptés à la réalisation des électrodes sont le polymère connu sous la dénomination PEDOT:PSS, qui est un mélange de poly(3,4)-éthylène-dioxythiophène et de polystyrène sulfonate de sodium ou le polyaniline, également appelé PAni. Des exemples de métaux adaptés à la réalisation des électrodes sont l'argent (Ag), l'or (Au), le cuivre (Cu), le nickel (Ni), le titane (Ti), le chrome (Cr). Un exemple de structure multicouche adaptée à la réalisation des électrodes est une structure multicouche d'AZO et d'argent de type AZO/Ag/AZO. L'épaisseur des électrodes 14, 16, 20, 22 peut être comprise entre 10 nm et 5 µm, par exemple de l'ordre de 30 nm. Ces couches peuvent être déposées par un procédé de dépôt sous vide (évaporation, pulvérisation...), un procédé de dépôt par voie liquide (sol-gel, dispersions, nanoparticules...) ou tout autre type de procédé de dépôt. Dans le cas où une électrode 14, 16, 20, 22, 36, 42, 44 est métallique et doit être au moins partiellement transparente, l'épaisseur de l'électrode est inférieure ou égale à 20 nm, de préférence inférieure ou égale à 10 nm.

La portion semiconductrice 18 qui correspond à un canal transporteur d'électrons est, par exemple, réalisée en naphtalène, en pérylène diimide, en phtalocyanine de cuivre ou en thiophène comprenant des chaînes latérales perfluorées ou des groupements fluoro ou des groupements cyano sur les cycles aromatiques. A titre d'exemple, la portion semiconductrice 18 est en pérylène diimide, notamment le PDI8-CN2. L'épaisseur de la portion semiconductrice 18 peut être comprise entre 1 nm et 1 µm, par exemple de l'ordre de 90 nm.

La portion semiconductrice 24 qui correspond à un canal transporteur de trous peut être un polymère semiconducteur, des petites molécules organiques, des nanofils ou des nanotubes de carbone, ou du TCO.

Des exemples de polymères semiconducteurs dopés de type P adaptés pour réaliser la portion semiconductrice 24 sont le poly(9,9-dioctylfluorene-co-N-(4-butylphényl)diphénylamine (TFD) et le poly(triaryl amine) (PTAA). Des exemples de petites molécules organiques adaptées pour réaliser la portion semiconductrice 24 sont le 6,13-Bis(triisopropylsilyléthynyl) pentacène (TIPS pentacène). Des exemples de TCO adaptés pour réaliser la portion semiconductrice 24 sont un oxyde d'indium-gallium-zinc (IGZO, de l'anglais Indium Gallium Zinc Oxide), un oxyde d'indium-zinc (IZO, de l'anglais Indium Zinc Oxide) ou l'oxyde d'indium (In₂O₃).

La couche active 30 peut comprendre des petites molécules, des oligomères ou des polymères. Il peut s'agir de matériaux organiques ou inorganiques. La couche active 30 peut comprendre un matériau semiconducteur ambipolaire, ou un mélange d'un matériau semiconducteur de type N et d'un matériau semiconducteur de type P, par exemple sous forme de couches superposées ou de mélange intime à l'échelle nanométrique de façon à former une hétérojonction en volume. L'épaisseur de la couche active 30 peut être comprise entre 50 nm et 500 nm, par exemple de l'ordre de 200 nm.

Des exemples de polymères semiconducteurs de type P adaptés à la réalisation de la couche active 30 sont le poly(3-hexylthiophène) (P3HT), le poly[N- 9'-heptadécanyl-2,7-carbazole-alt-5,5-(4,7-di-2-thiényl-2',1',3'-benzothiadiazole] (PCDTBT), le Poly[(4,8-bis-(2-éthylhexyloxy)-benzo[1,2-b;4,5-b']dithiophène)-2,6-diyl-alt-(4-(2-éthylhexanoyl)-thie-no[3,4-b]thiophène))-2,6-diyl];4,5-b']dithi-ophène)-2,6-diyl-alt-(5,5'-bis(2-thiényl)-4,4,-dinonyl-2,2'-bithiazole)-5',5"-diyl] (PBDTTT-C), le poly[2-méthoxy-5-(2-éthyl-hexyloxy)-1,4-phény-lène-vinylène] (MEH-PPV) ou le Poly[2,6-(4,4-bis-(2-éthylhexyl)-4*H*-cyclopenta [2,1-*b*;3,4-*b*']dithiophène)-*alt*-4,7(2,1,3-benzo-thiadiazole)] (PCPDTBT).

Des exemples de matériaux semiconducteurs de type N adaptés à la réalisation de la couche active 30 sont les fullerènes, notamment le C60, le [6,6]-phényl-C₆₁-butanoate de méthyle ([60]PCBM), le [6,6]-phényl-C₇₁-butanoate de méthyle ([70]PCBM), le pérylène diimide, l'oxyde de zinc (ZnO) ou des nanocristaux permettant la formation de boîtes quantiques, en anglais quantum dots.

La couche d'interface 32 peut être réalisée en oxyde de zinc (ZnO), en carbonate de césium (CSCO₃) ou en un mélange d'au moins deux de ces composés. La couche d'interface 32 est de préférence réalisée en un oxyde métallique, plus préférentiellement en oxyde de zinc. La couche d'interface 32 peut comprendre une couche monomoléculaire auto-assemblée ou un polymère par exemple du (polyéthyléneimine, polyéthyléneimine éthoxylé, poly[(9,9-bis(3'-(N,N-dimethylamino)propyl)-2,7-fluorene)-alt-2,7-(9,9-dioctylfluorene)].

La couche d'interface 34 peut être réalisée en oxyde de cuivre (CuO), en oxyde de nickel (NiO), en oxyde de vanadium (V₂O₅), en oxyde de magnésium (MgO), en oxyde de tungstène (WO3) ou en un mélange d'au moins deux de ces composés.

La couche diélectrique 40 peut être réalisée en polymère fluoré, notamment le polymère fluoré commercialisé sous l'appellation Cytop par la société Bellex, en polyvinyl-pyrrolidone (PVP), en polyméthacrylate de méthyle (PMMA), en polystyrène (PS), en parylène, en polyimide (PI) ou en un mélange d'au moins deux de ces composés. L'épaisseur de la couche diélectrique au niveau de chaque transistor M1, M2 peut être comprise entre 50 nm et 2 µm, par exemple de l'ordre de 200 nm.

La figure 2 représente des courbes d'évolution C₁ à C₄ du courant entre le drain et la source traversant le transistor M1 en fonction de la tension de grille pour un essai dans lequel la couche d'interface 32 n'était pas interposée entre la portion semiconductrice 18 et la couche diélectrique 40 (courbes C₁ et C₂) et pour un essai dans lequel la couche d'interface 32 était interposée entre la portion semiconductrice 18 et la couche diélectrique 40 (courbes C₃ et C₄). Les courbes C₁ et C₃ ont été obtenues avec une tension drain-source de -5 V et les courbes C₂ et C₄ ont été obtenues avec une tension drain-source de -40 V. Ces essais ont été réalisés avec un transistor M1 pour lequel le support 12 était en PEN, les électrodes 14 et 16 étaient en or et avaient une épaisseur de 30 nm, la portion semiconductrice 18 était en pérylène diimide et avait une épaisseur de 90 nm, la couche d'interface 32 était en ZnO et avait une épaisseur de 30 nm, la couche active 30 était un mélange de P3HT et C60 et avait une épaisseur de 200 nm, la couche d'interface 34 était en PEDOT:PSS et avait une épaisseur de 300 nm, la couche de diélectrique 40 était en diélectrique Cytop et avait une épaisseur de 700 nm et les électrodes 42, 44 étaient en argent et avaient une épaisseur de 100 nm.

La couche d'interface 32 a permis d'améliorer la conduction du transistor M1. En outre, la couche d'interface 32 a permis d'augmenter la pente de la courbe à la transition entre l'état passant et l'état bloqué du transistor pour les courbes C₃ et C₄ par rapport aux courbes C₁ et C₂. Ceci traduit une diminution des pièges d'interface au niveau de la face externe de la portion semiconductrice 18 lorsque la portion 33 de la couche d'interface 32 est présente.

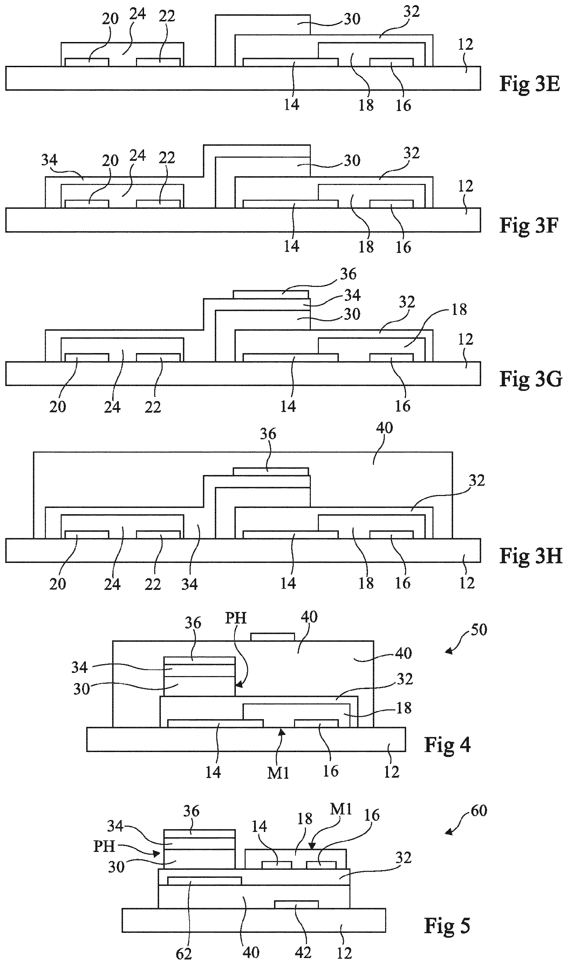

Les figures 3A à 3H illustrent un mode de réalisation d'un procédé de fabrication du dispositif 10 comprenant les étapes suivantes :
- Formation des électrodes 14, 16, 20, 22 sur le support 12 (figure 3A). Selon le matériau utilisé, le procédé de formation des électrodes 14, 16, 20, 22 peut correspondre à un procédé dit additif, par exemple par impression directe du matériau composant les électrodes 14, 16, 20, 22 aux emplacements souhaités notamment sous forme de sol-gel, par exemple par impression par jet d'encre, héliographie, sérigraphie, flexographie, revêtement par pulvérisation (en anglais spray coating) ou dépôt de gouttes (en anglais drop-casting). Le procédé de formation des électrodes 14, 16, 20, 22 peut correspondre à un procédé dit soustractif, dans lequel le matériau composant les électrodes 14, 16, 20, 22 est déposé sur la totalité de la structure et dans lequel les portions non utilisées sont ensuite retirées, par exemple par photolithographie ou ablation laser. Selon le matériau considéré, le dépôt sur la totalité de la structure peut être réalisé par exemple par voie liquide, par pulvérisation cathodique ou par évaporation. Il peut s'agir notamment de procédés du type dépôt à la tournette, revêtement par pulvérisation, héliographie, revêtement par filière (en anglais slot-die coating), revêtement à la lame (en anglais blade-coating), flexographie ou sérigraphie. Lorsque les électrodes 14, 16, 20, 22 sont métalliques, le métal est, par exemple, déposé par évaporation ou par pulvérisation cathodique sur l'ensemble du support 12 et les électrodes 14, 16, 20, 22 sont délimitées par gravure.
- Formation de la portion semiconductrice 18 (figure 3B).
- Formation de la couche d'interface 32 (figure 3C).
- Formation de la couche active 30 (figure 3D).
- Formation de la portion semiconductrice 24 (figure 3E).
- Formation de la couche d'interface 34 (figure 3F).
- Formation de l'électrode 36 (figure 3G).
- Formation de la couche diélectrique 40 (figure 3H).
- Formation des électrodes 42 et 44.

La couche d'interface 32, la couche active 30, la couche d'interface 34, la couche diélectrique 40 et les électrodes 36, 42, 43 peuvent être réalisées, en fonction des matériaux utilisés, selon tout ou partie des procédés décrits précédemment pour la formation des électrodes 14, 16, 20, 22.

Lorsque la couche d'interface 32 est déposée sous la forme d'une solution de nanoparticules ou d'un sol-gel, le solvant du matériau de la couche d'interface 32 est choisi pour ne pas dissoudre le matériau de la portion semiconductrice 18. Lorsque la couche d'interface 32 est en oxyde métallique, un grand choix de solvants pour l'oxyde métallique est disponible dans lequel le matériau organique de la portion semiconductrice 18 ne se dissous pas, par exemple un solvant à base d'eau, d'alcool (notamment l'éthanol, l'isopropanol, le butanol), l'acétone, l'acétyle éthyle, l'acétyle méthyle ou le butyl-acétate.

Selon une variante, la portion semiconductrice 24 peut être formée après la couche d'interface 32 et avant la couche active 30. Dans ce cas, la portion 35 de la couche d'interface 34 recouvrant la portion semiconductrice 24 est formée avant la couche active 30 et le reste de la couche d'interface 34 est formé après la couche active 30.

Dans le cas où la portion semiconductrice 18 ou 24 est formée par un procédé soustractif dans lequel une couche du matériau de la portion semiconductrice est déposée sur la totalité de la structure puis est gravée, la couche d'interface 32 peut, de façon avantageuse, être utilisée comme masque pour la gravure délimitant la portion semiconductrice 18. Comme la couche d'interface 32 est conservée, on évite une étape de retrait du masque de gravure de la portion semiconductrice 18 qui entraîne une dégradation de la surface externe de la portion semiconductrice 18.

La figure 4 représente un autre mode de réalisation (non compris dans l'invention) d'un dispositif électrique 50 qui comprend l'ensemble des éléments du dispositif 10 représenté en figure 1 à la différence que le transistor M2 n'est pas présent.

La figure 5 représente un autre mode de réalisation (non compris dans l'invention) d'un dispositif électrique 60 qui reprend l'ensemble des éléments du dispositif 50 représenté en figure 4 à la différence que les positions relatives des éléments du transistor M1 sont inversées. Plus précisément, dans le dispositif 50, la grille 42 du transistor M1 repose sur le support 12. De plus, la couche diélectrique 40 formant l'oxyde de grille du transistor M1 recouvre le support 12 et l'électrode de grille 62 et la couche d'interface 32 recouvre la couche diélectrique 64 et l'électrode 66. En outre, les électrodes de source et de drain 14, 16 sont formées sur la couche d'interface 32 et la portion semiconductrice 18 est formée sur la couche d'interface 68 et recouvre les électrodes 14, 16. Le dispositif 50 comprend, en outre, une portion conductrice 62 qui est formée sur la couche diélectrique 40 et forme la cathode de la photodiode PH.

Un avantage du dispositif 60 est qu'il permet l'utilisation d'une couche diélectrique 40 plus fine que le dispositif 10 ou 50.

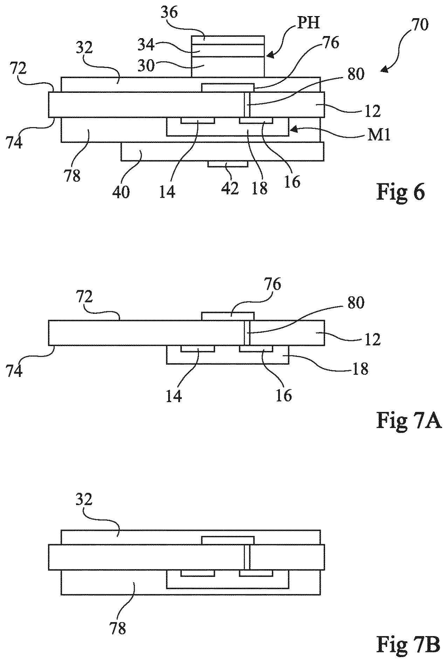

La figure 6 représente un autre mode de réalisation (non compris dans l'invention) d'un dispositif électronique 70. Dans ce mode de réalisation, le support 12 comprend deux faces opposées 72, 74. La photodiode PH est réalisée du côté de la face 72 tandis que le transistor M1 est réalisé du côté de la face 74. Le dispositif électronique 70 comprend une portion conductrice 76 sur la face 72 formant la cathode de la photodiode PH. La couche d'interface 32 recouvre l'électrode 76 et la face 72. Le reste de la photodiode PH a la même structure que celle décrite précédemment en relation avec la figure 4 ou 5.

Un avantage du dispositif 70 est qu'il présente un encombrement réduit par rapport aux dispositifs 10, 50 et 60. En outre, le transistor M1 peut être mieux protégé de la lumière, notamment par le support 12 et l'électrode 42.

Les électrodes 14, 16 de drain et de source du transistor M1 sont formées sur la face 74. La portion semiconductrice 18 recouvre les électrodes 14, 16 et s'étend sur la face 74 entre les électrodes 14, 16. Une couche 78, du même matériau que la couche d'interface 32, recouvre les électrodes 14, 16 et la portion semiconductrice 18. La couche diélectrique 40 recouvre la couche 78 et l'électrode de grille 42 du transistor M1 est formée sur la couche diélectrique 40. Dans le présent mode de réalisation, l'électrode 16 du transistor M1 est connectée à l'électrode 76 de la photodiode PH par un via conducteur 80 traversant le support 12.

Les figures 7A et 7B illustrent des étapes d'un mode de réalisation d'un procédé de fabrication du dispositif électronique 70.

La figure 7A représente la structure obtenue après avoir formé le via 80 traversant le support 12, l'électrode 76 sur la face 72 et les électrodes 14, 16 sur la face 74 et après avoir formé la portion semiconductrice 18 sur la face 74 du support 12.

La figure 7B représente la structure obtenue après avoir plongé la structure représentée en figure 7A dans un bain du matériau composant la couche d'interface 32, qui est par exemple sous la forme d'un sol-gel, après avoir retiré la structure du bain et après avoir fait sécher la structure. Les couches 32 et 78 sont alors obtenues. Les étapes ultérieures du procédé comprennent la formation des couches restantes de la photodiode PH et des couches restantes du transistor M1.

Des modes de réalisation particuliers ont été décrits. Diverses variantes et modifications apparaissent à l'homme de l'art. En particulier, bien que dans les modes de réalisation décrits précédemment, un ou deux transistors à effet de champ soient associés au composant opto-électronique, il est clair que plus de deux transistors à effet de champ peuvent être associés au composant opto-électronique. Divers modes de réalisation avec diverses variantes ont été décrits ci-dessus. On note que l'homme de l'art peut combiner divers éléments de ces divers modes de réalisation et variantes sans faire preuve d'activité inventive. En particulier, dans la structure du dispositif électronique 70, il peut être prévu en plus du transistor M1, disposé du côté du support 12 opposé à la photodiode PH, d'autres transistors ayant la structure des transistors des dispositifs 10, 50 ou 60.

## Revendications

1. Dispositif électronique (10) comprenant au moins un composant opto-électronique (PH) comprenant une première couche active (30), une première électrode (14) et une deuxième couche (32) d'interface entre la première couche et la première électrode et au moins un premier transistor à effet de champ (M1) comprenant une première portion semiconductrice (18) et une première grille (42) et au moins une troisième couche (33) entre la première grille et la première portion semiconductrice, la troisième couche étant du même matériau que la deuxième couche, **caractérisé en ce que** le dispositif électronique comprend une deuxième électrode (36) et une quatrième couche (34) d'interface entre la première couche (30) et la deuxième électrode et comprend un deuxième transistor à effet de champ (M2) comprenant une deuxième portion semiconductrice (24), une deuxième grille (44) et au moins une cinquième couche (35) entre la deuxième grille et la deuxième portion semiconductrice, la cinquième couche étant du même matériau que la quatrième couche.

2. Dispositif électronique selon la revendication 1, comprenant, en outre, une quatrième couche diélectrique (40) interposée entre la troisième couche (33) et la première grille (42).

3. Dispositif électronique selon la revendication 1 ou 2, dans lequel la troisième couche (33) comprend un matériau choisi parmi l'oxyde de zinc, l'oxyde de titane, le carbonate de césium ou un mélange d'au moins deux de ces composés, la résistance électrique de la troisième couche (33) étant supérieure ou égale à 10⁹ Ω/□.

4. Dispositif électronique selon l'une quelconque des revendications 1 à 3, dans lequel l'épaisseur de la troisième couche (33) est comprise entre 0,1 nm et 500 nm.

5. Dispositif électronique selon l'une quelconque des revendications 1 à 4, dans lequel la première couche (30) comprend au moins un premier matériau organique.

6. Dispositif électronique selon l'une quelconque des revendications 1 à 5, dans lequel la première portion semiconductrice (18) comprend un deuxième matériau organique.

7. Dispositif électronique selon l'une quelconque des revendications 1 à 6, dans lequel la deuxième couche (32) comprend un matériau choisi parmi l'oxyde de zinc, l'oxyde de titane, le carbonate de césium ou un mélange d'au moins deux de ces composés.

8. Dispositif électronique selon l'une quelconque des revendications 1 à 7, dans lequel la troisième couche (33) est un prolongement de la deuxième couche (32).

9. Dispositif électronique selon l'une quelconque des revendications 1 à 8, dans lequel la cinquième couche (35) est un prolongement de la quatrième couche (34).

10. Dispositif électronique selon l'une quelconque des revendications 1 à 9, dans lequel le premier transistor (M1) est de type N et le deuxième transistor (M2) est de type P.

11. Dispositif électronique selon l'une quelconque des revendications 1 à 10, comprenant un support (12), la première grille (42) reposant sur une face du support.

12. Dispositif électronique selon l'une quelconque des revendications 1 à 11, comprenant un support (12) ayant des première et deuxième faces opposées (72, 74), le composant opto-électronique (PH) étant disposé du côté de la première face (72) et le premier transistor (M1) étant disposé du côté de la deuxième face (74).

## Patentansprüche

1. Elektronische Vorrichtung (10) die Folgendes aufweist wenigstens eine optoelektronischen Komponente (PH), mit einer erste aktiven Schicht (30), einer ersten Elektrode (14) und einer zweiten Grenzflächenschicht (32) zwischen der ersten Schicht und der ersten Elektrode und wenigstens einen ersten Feldeffekttransistor (M1) mit einem ersten Halbleiterabschnitt (18) und einem ersten Gate (42) und mindestens einer dritten Schicht (33) zwischen dem ersten Gate und dem ersten Halbleiterabschnitt, wobei die dritte Schicht aus dem gleichen Material wie die zweite Schicht besteht, **dadurch gekennzeichnet, dass** die elektronische Vorrichtung eine zweite Elektrode (36) und eine vierte Schnittstellenschicht (34) zwischen der ersten Schicht (30) und der zweiten Elektrode aufweist sowie einen zweiten Feldeffekttransistor (M2) mit einem zweiten Halbleiterabschnitt (24), einem zweiten Gate (44) und wenigstens einer fünfte Schicht (35) zwischen dem zweiten Gate und dem zweiten Halbleiterabschnitt, wobei die fünfte Schicht aus dem gleichen Material wie die vierte Schicht besteht.

2. Elektronische Vorrichtung nach Anspruch 1, ferner aufweisend eine vierte dielektrische Schicht (40), die zwischen der dritten Schicht (33) und dem ersten Gate (42) angeordnet ist.

3. Elektronische Vorrichtung nach Anspruch 1 oder 2, wobei die dritte Schicht (33) ein Material aufweist, aus den Folgenden ausgewählt ist: Zinkoxid, Titanoxid, Cäsiumcarbonat oder einer Mischung aus wenigstens zwei dieser Verbindungen, wobei der elektrische Widerstand der dritten Schicht (33) größer oder gleich 10⁹ Ω/□ ist.

4. Elektronische Vorrichtung nach einem der Ansprüche 1 bis 3, wobei die Dicke der dritten Schicht (33) im Bereich von 0,1 nm bis 500 nm liegt.

5. Elektronische Vorrichtung nach einem der Ansprüche 1 bis 4, wobei die erste Schicht (30) wenigstens ein erstes organisches Material aufweist.

6. Elektronische Vorrichtung nach einem der Ansprüche 1 bis 5, wobei der erste Halbleiterabschnitt (18) ein zweites organisches Material aufweist.

7. Elektronische Vorrichtung nach einem der Ansprüche 1 bis 6, wobei die zweite Schicht (32) ein Material umfasst, das den Folgenden ausgewählt ist: Zinkoxid, Titanoxid, Cäsiumcarbonat oder einer Mischung aus wenigstens zwei dieser Verbindungen.

8. Elektronische Vorrichtung nach einem der Ansprüche 1 bis 7, wobei die dritte Schicht (33) eine Verlängerung der zweiten Schicht (32) ist.

9. Elektronische Vorrichtung nach einem der Ansprüche 1 bis 8, wobei die fünfte Schicht (35) eine Verlängerung der vierten Schicht (34) ist.

10. Elektronische Vorrichtung nach einem der Ansprüche 1 bis 9, wobei der erste Transistor (M1) vom N-Typ und der zweite Transistor (M2) vom P-Typ ist.

11. Elektronische Vorrichtung nach einem der Ansprüche 1 bis 10, aufweisend einen Träger (12), wobei das erste Gate (42) auf einer Oberfläche des Trägers aufliegt.

12. Elektronische Vorrichtung nach einem der Ansprüche 1 bis 11, aufweisend einen Träger (12) mit ersten und zweiten gegenüberliegenden Oberflächen (72, 74), wobei die optoelektronische Komponente (PH) auf der Seite der ersten Oberfläche (72) und der erste Transistor (M1) auf der Seite der zweiten Oberfläche (74) angeordnet ist.

## Claims

1. An electronic device (10) comprising at least one optoelectronic component (PH) comprising a first active layer (30), a first electrode (14), and a second interface layer (32) between the first layer and the first electrode and at least one first field-effect transistor (M1) comprising a first semiconductor portion (18) and a first gate (42) and at least one third layer (33) between the first gate and the first semiconductor portion, the third layer being made of the same material as the second layer, **characterized in that** the electronic device comprises a second electrode (36) and a fourth interface layer (34) between the first layer (30) and the second electrode and comprises a second field-effect transistor (M2) comprising a second semiconductor portion (24), a second gate (44), and at least one fifth layer (35) between the second gate and the second semiconductor portion, the fifth layer being made of the same material as the fourth layer.

2. The electronic device of claim 1, further comprising a fourth dielectric layer (40) interposed between the third layer (33) and the first gate (42).

3. The electronic device of claim 1 or 2, wherein the third layer (33) comprises a material selected from zinc oxide, titanium oxide, cesium carbonate, or a mixture of at least two of these compounds, the electric resistance of the third layer (33) being greater than or equal to 10⁹ Ω/□.

4. The electronic device of any of claims 1 to 3, wherein the thickness of the third layer (33) is in the range from 0.1 nm to 500 nm.

5. The electronic device of any of claims 1 to 4, wherein the first layer (30) comprises at least one first organic material.

6. The electronic device of any of claims 1 to 5, wherein the first semiconductor portion (18) comprises a second organic material.

7. The electronic device of any of claims 1 to 6, wherein the second layer (32) comprises a material selected from zinc oxide, titanium oxide, cesium carbonate, or a mixture of at least two of these compounds.

8. The electronic device of any of claims 1 to 7, wherein the third layer (33) is an extension of the second layer (32).

9. The electronic device of any of claims 1 to 8, wherein the fifth layer (35) is an extension of the fourth layer (34).

10. The electronic device of any of claims 1 to 9, wherein the first transistor (M1) is of type N and the second transistor (M2) is of type P.

11. The electronic device of any of claims 1 to 10, comprising a support (12), the first gate (42) resting on a surface of the support.

12. The electronic device of any of claims 1 to 11, comprising a support (12) having first and second opposite surfaces (72, 74), the optoelectronic component (PH) being arranged on the first surface side (72) and the first transistor (M1) being arranged on the second surface side (74).
